# FASCICULE DE BREVET EUROPEEN

(11) **EP 2 318 572 B1**
(45) Date de publication et mention de la délivrance du brevet: **16.05.2018**
(21) Numéro de dépôt: 09740402.4
(22) Date de dépôt: 28.07.2009
(51) Int. Cl.: C25D 7/08, C25D 9/08, H01L 31/18, H01L 31/0749, C25D 9/04

(54) **ELABORATION DE COUCHE D'OXYDE TRANSPARENTE ET CONDUCTRICE POUR UTILISATION DANS UNE STRUCTURE PHOTOVOLTAÏQUE**
BILDUNG EINES TRANSPARENTEN LEITFÄHIGEN OXIDFILMS ZUR VERWENDUNG IN EINER PHOTOVOLTAIKSTRUKTUR
FORMATION OF A TRANSPARENT CONDUCTIVE OXIDE FILM FOR USE IN A PHOTOVOLTAIC STRUCTURE

(30) Priorité: 01.08.2008 FR 0855344
(43) Date de publication de la demande: 11.05.2011
(73) Titulaire: Electricité de France, 75008 Paris (FR); Centre National de la Recherche Scientifique (C.N.R.S.), 75794 Paris Cedex 16 (FR)
(72) Inventeur: LINCOT, Daniel, 92160 Antony (FR); ROUSSET, Jean, 75014 Paris (FR)
(74) Mandataire: Cabinet Plasseraud
(86) Numéro de dépôt international: PCT/FR2009/051518
(87) Numéro de publication internationale: WO 2010/012955

(56) Documents cités:
- EP-A- 0 841 706
- WO-A-2009/015886
- US-A- 4 507 181
- US-A- 4 644 638
- US-A- 4 657 833
- ENNAOUI A ET AL: "Chemical-bath ZnO buffer layer for CuInS2 thin-film solar cells" SOLAR ENERGY MATERIALS AND SOLAR CELLS, ELSEVIER SCIENCE PUBLISHERS, AMSTERDAM, NL, vol. 54, no. 1-4, 1 juillet 1998 (1998-07-01), pages 277-286, XP004148898 ISSN: 0927-0248
- GAL D ET AL: "Electrochemical deposition of zinc oxide films from non-aqueous solution: a new buffer/window process for thin film solar cells" THIN SOLID FILMS, ELSEVIER-SEQUOIA S.A. LAUSANNE, CH, vol. 361-362, no. 1, 1 février 2000 (2000-02-01), pages 79-83, XP004187446 ISSN: 0040-6090 cité dans la demande

## Description

La présente invention concerne l'élaboration d'une couche mince de revêtement utilisable au sein d'un dispositif photovoltaïque tel qu'une cellule solaire par exemple.

Cette couche de revêtement peut typiquement être une couche conductrice et transparente pour servir d'électrode « avant » dans la structure photovoltaïque. Les propriétés requises pour cette couche sont d'être :
- transparente dans le visible et
- conductrice dans la cellule solaire.
Cette couche de revêtement est souvent réalisée dans un matériau comportant majoritairement un oxyde tel que l'oxyde de zinc (ZnO).

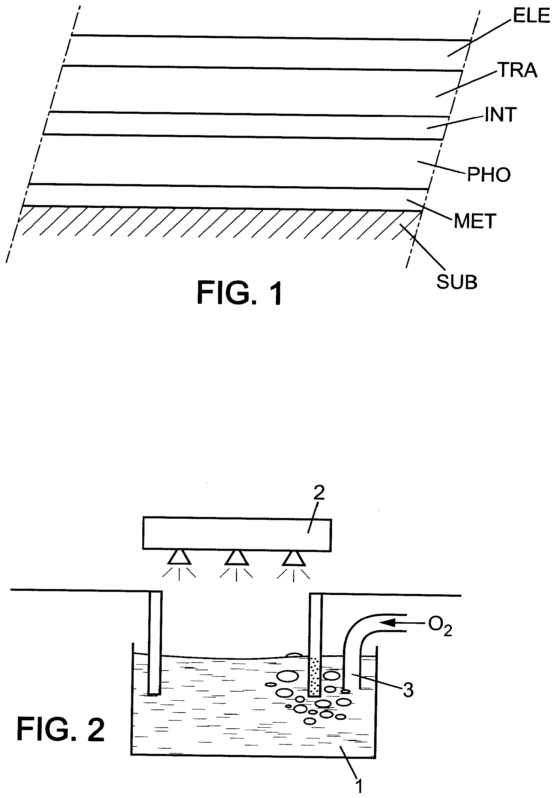

On se réfère à la figure 1 représentant schématiquement une structure photovoltaïque susceptible de comporter une telle couche de revêtement.

Une couche métallique MET (par exemple à base de molybdène) est déposée sur un substrat SUB (par exemple par évaporation sous vide ou par pulvérisation ou « sputtering »). Le substrat peut être en verre classique. Cette couche métallique MET présente une épaisseur qui peut être comprise entre 0,5 et 1 micron.

Ensuite, une couche à propriétés photovoltaïques PHO est déposée sur la couche métallique MET. Le matériau de la couche PHO peut être du silicium, du CdTe ou encore un alliage I-III-VI₂ comportant typiquement :
- du cuivre,
- de l'indium, du gallium et/ou de l'aluminium
- et du sélénium et/ou du soufre.
La couche PHO est typiquement d'épaisseur d'environ 2 microns. Elle est généralement déposée par évaporation sous vide, par pulvérisation cathodique, par dépôt chimique en phase vapeur, par sérigraphie ou encore par électrochimie.

Il est habituellement déposé sur cette couche photovoltaïque PHO une couche d'interface INT, appelée « couche tampon », souvent à base de sulfure de cadmium, à base de sulfure de zinc ou de sulfure d'indium. Elle peut être déposée par voie chimique en solution (technique de dépôt appelée « CBD » pour « chemical bath deposition »), sous vide ou en phase vapeur . Son épaisseur est comprise généralement entre 5 et 100 nm.

Les deux couches suivantes référencées respectivement ELE et TRA, qui sont déposées sur la couche tampon INT dans l'exemple illustré sur la figure 1, font en particulier l'objet de la présente invention. La couche TRA, en elle-même, est optionnelle mais la couche superficielle ELE joue le rôle d'électrode dans la structure photovoltaïque.

La couche TRA doit être transparente pour laisser la lumière atteindre la couche photovoltaïque PHO. Elle peut être à base d'oxyde (par exemple à base de ZnO peu dopé) et présenter une épaisseur d'environ 50 à 100 nm. Elle est généralement déposée par pulvérisation cathodique ou par voie chimique en phase vapeur (ou « CVD »).

La couche ELE est d'épaisseur variant de 0,5 à 1 micron. Elle peut être à base d'oxyde (par exemple d'oxyde de zinc) comme la couche TRA. La couche ELE est dopée, quant à elle, dans le but de rendre cette couche ELE conductrice pour servir d'électrode « avant ». Le dopage peut être de type n, par exemple à l'aluminium. La couche ELE doit être transparente dans le visible pour que la couche photovoltaïque PHO puisse être éclairée. Elle doit être aussi conductrice dans la cellule solaire.

Les cellules solaires à base d'alliages de type CuInSe₂ utilisant l'addition du soufre, du gallium ou de l'aluminium sont à la base d'une nouvelle filière photovoltaïque dont l'essor industriel commence. Les performances de telles cellules vont jusqu'à 19,9% en laboratoire, avec en général des valeurs standards en laboratoire de 15-17 %. Les modules ont des rendements de :
- 11-14% pour la filière utilisant le gallium ajouté à l'alliage photovoltaïque I-III-VI₂ et
- de l'ordre de 6-9% pour la filière utilisant le soufre.
Tous ces dispositifs photovoltaïques présentent, sans exception, la structure illustrée sur la figure 1.

Habituellement, la couche superficielle ELE est déposée par pulvérisation sous vide. Dans certains cas, elle peut être déposée par dépôt chimique en phase vapeur et dopée au bore.

Toutefois, pour une mise en oeuvre à l'échelle industrielle, il est préférable d'utiliser une méthode de dépôt atmosphérique, telle qu'un dépôt par électrochimie en solution. Cette technique est simple Elle ne nécessite pas l'application de vide. Elle présente un avantage net en matière de coût de production, d'investissement, et de capacité de traitement de grandes surfaces (comme dans le domaine de la galvanoplastie notamment).

Par ailleurs, comme cette technique de dépôt se situerait dans la continuité du dépôt par voie chimique de la couche sous-jacente TRA (par exemple à base de CdS ou de ZnS), voire même de la couche à propriétés photovoltaïques PHO déposée par électrochimie, la cohérence de la chaine d'élaboration est respectée, avec une approche dite de « face avant » entièrement déposée par voie humide. L'avantage en termes de coût de production est significatif.

La synthèse électrochimique d'un matériau couramment utilisé pour la fabrication de la couche superficielle ELE ou de la couche TRA, en particulier l'oxyde de zinc ZnO, a été décrite dans le document WO96/31638. Dans ce document, l'apport d'oxygène provient de l'oxygène moléculaire dissous dans le bain d'électrolyse. Dans un autre document (M. Izaki, T. Omi, T.A. Pattinson, Appl. Phys.Lett, 68, 2439, 1996*),* l'oxygène provient d'ions nitrate.

### Le document :

D. Lincot, B. Cavana, S. Quenet, S. Peulon, H.W. Schock, Proceedings 14th EC Photovoltaic Solar Energy Conference, Stephen and Ass. Ed, 2168, 1997,
montre en outre qu'il est possible de déposer des couches superficielles d'oxyde de zinc directement sur un empilement de molybdène et d'un alliage I-III-VI₂ avec un rendement proche de 10%. L'électrodépôt peut donc être utilisé dans la synthèse de couches conductrices de ZnO en tant que couche fenêtre dans des cellules photovoltaïques à base d'un alliage de type dit « CIS » (pour Cu(In,Ga)(Se,S)₂).

### Le document :

D. Gal, G. Hodes, D. Lincot, H.W. Hodes, Thin Solid Films, 361-362, 79, 2000,
traite du dépôt direct de couches d'oxyde transparent INT de ZnO sur CIS, à partir d'un milieu comportant du dimethylsulfoxide (DMSO) porté à 130°C et en présence d'oxygène dissous. L'empilement est ensuite complété par une couche ELE de ZnO dopé à l'aluminium. Cette couche est donc conductrice et elle est déposée par pulvérisation (ou « sputtering »). Ainsi, dans ce document, il n'est pas question de remplacer la technique de dépôt (sputtering) de la couche conductrice ELE superficielle, mais d'appliquer la technique d'électrodépôt à la synthèse de la couche sous-jacente TRA (à base de ZnO) et d'éventuelles autres couches tampon.

Ainsi, le dépôt de couches d'oxyde transparent conducteur, au-dessus de la couche à propriétés photovoltaïques, par électrochimie, est une technique particulièrement avantageuse. Elle a déjà vu le jour dans le domaine des cellules photovoltaïques. Toutefois, les résultats obtenus peuvent encore être améliorés. En particulier, l'adhérence des couches ainsi déposées, leur homogénéité et leur qualité morphologique méritent encore des perfectionnements.
US 4 644 638 A, US 4 507 181 A et US 4 657 833 A décrivent la fabrication d'une structure photovoltaïque par dépôt électrochimique assisté par un éclairement d'une couche de revêtement sur une couche à propriétés photovoltaïques, ainsi que l'installation correspondante.

En outre, le document ENNAOUI ET AL Chemical-bath ZnO buffer layer for CuInS2 thin-film solar cells SOLAR ENERGY MATERIALS AND SOLAR CELLS, ELSEVIER SCIENCE PUBLISHERS, AMSTERDAM, NL, vol. 54, no. 1-4, 1 juillet 1998, pages 277-286 décrit la fabrication d'une structure photovoltaïque comportant une couche à base d'oxyde de zinc déposée au-dessus d'une sous-couche à propriétés photovoltaïques, et ce par électrochimie.

La présente invention vient améliorer la situation.

Elle propose à cet effet un procédé de fabrication d'une structure photovoltaïque selon la revendication 1 Le procédé selon la présente invention comprend les caractéristiques d'une ou plusieurs des revendications 1 à 13. En outre, l'invention porte sur une installation selon la revendication 14.

Il a pu être observé alors que l'éclairement de la couche photovoltaïque provoquait un effet électrique propre à favoriser un dépôt uniforme et homogène de la couche de revêtement, au moins en début de croissance de la couche de revêtement (étape appelée « nucléation »). En particulier, il a été observé que le dépôt, dès la nucléation, est uniforme latéralement et dense, ce qui était inattendu notamment pour le dépôt d'une couche d'oxyde tel que de l'oxyde de zinc. L'effet de l'éclairement peut s'expliquer par une densité de charge générée par la couche photovoltaïque qui est uniformément répartie sur la surface accueillant le dépôt de la couche de revêtement, ce qui favorise une bonne morphologie homogène de la couche de revêtement. Cet effet satisfaisant est dû aussi à un choix d'une température adéquate de dépôt, préférentiellement dans une gamme comprise entre 50°C et 150°C (en milieu aqueux, non aqueux ou mixte, selon la température choisie). En effet, dans cette gamme de température, la formation de l'oxyde de zinc est favorisée. Il a été observé en particulier qu'à plus basse température (température ambiante par exemple), la présence d'hydroxydes (Zn(OH)₂ par exemple) est prépondérante, alors qu'à plus haute température (par exemple autour de 70 à 80°C), la présence d'oxyde de zinc est prépondérante. Ainsi, la combinaison d'un éclairement et d'une température adéquate de dépôt permet d'obtenir les résultats satisfaisants. Il a été observé en outre que l'éclairement permettait aussi d'augmenter la vitesse de croissance de la couche de revêtement. L'épaisseur de la couche de revêtement peut alors aller jusqu'à quelques microns et présenter néanmoins une bonne stabilité mécanique.

Il a également été observé que l'étape de nucléation de la couche de revêtement faite dans des conditions de température et d'éclairement donnée était généralement améliorée en présence d'une couche d'interface (INT) ou des couches INT et TRA, par rapport à l'utilisation d'une couche PHO nue. Ce résultat conduit à une augmentation spectaculaire des performances photovoltaïques, ce qui n'avait jamais été observé précédemment. Cela a été obtenu malgré la fragilité des couches INT et TRA.

Comme indiqué précédemment, la couche de revêtement est à base d'un oxyde de zinc (ZnO). La couche de ZnO transparente et conductrice est déposée par électrolyse dans un milieu aqueux ou dans un milieu non aqueux, par exemple le diméthylsulfoxyde, ou leur mélange, à partir d'ions zinc dissous et d'un élément donneur d'oxygène tel que de l'oxygène dissous, ou d'un autre précurseur (peroxyde d'hydrogène, ions nitrates ou tout autre précurseur d'oxygène soluble), par une réaction cathodique.

L'éclairement peut être dans le visible, sous forme monochromatique ou polychromatique. Une gamme spectrale comprise entre 100 et 1500 nm, par exemple entre 200 et 1300 nm (éclairement solaire), a donné de bons résultats, avec une puissance incidente comprise entre 0,1 mW/cm² et 1 W/cm² (préférentiellement entre 1 mW/cm² et 300 mW/cm² dans un exemple de réalisation).

La couche de revêtement peut être dopée ou non, par exemple par au moins un élément introduit en solution parmi le chlore, le fluor, l'iode, le brome, le gallium, l'indium, le bore et l'aluminium, et, dans une réalisation courante, elle peut être dopée au chlore en particulier.

Comme indiqué précédemment, la sous-couche photovoltaïque peut être à base d'un alliage I-III-VI₂ du type Cu(In,Ga,Al)(S,Se)₂ déposé par électrochimie, ou par toute autre technique telle que l'évaporation, la pulvérisation ou « sputtering », la sérigraphie, le dépôt chimique en phase vapeur ou par jet d'encre, et ce partiellement ou totalement.

Par exemple, les éléments I-III peuvent être déposés par électrolyse, ou encore par sputtering, puis une sélénisation et/ou une sulfurisation peuvent être menées ultérieurement. Une réalisation préférentielle est celle décrite dans le document WO-03/094246 où l'alliage I-III-VI₂ est déposé entièrement par électrochimie puis recuit par un processus rapide. Toutefois, d'autres matériaux photovoltaïques sont envisageables (par exemple du silicium en couche mince ou massif, ou autres).

La couche de revêtement peut être déposée directement sur la sous-couche photovoltaïque ou, en variante, être déposée sur une ou plusieurs couches d'interface situées au dessus de la sous-couche photovoltaïque.

D'ailleurs, ces autres couches d'interface peuvent être déposées par électrochimie ou par d'autres techniques. Les matériaux constituant ces couches peuvent être par exemple basées sur du sulfure de cadmium (CdS) et/ou du sulfure de zinc (ZnS) et/ou de sulfure d'indium ou de gallium (In₂S₃ ou Ga₂S₃ respectivement). Ces couches sont déposables par voie chimique en phase vapeur ou en solution, notamment CBD, ou par voie physique, évaporation pulvérisation cathodique, ou autres. Il est toutefois particulièrement avantageux de déposer ces couches par électrolyse encore, de sorte que :
- la sous-couche photovoltaïque,
- la (ou les) couche(s) d'interface, et
- la couche de revêtement (ZnO) sont toutes déposées par électrolyse, donc par un seul traitement de même type et sans avoir recours à d'autres techniques (sputtering ou autre).

Là encore, la possibilité d'un dépôt dense et homogène d'une couche de revêtement (ZnO) sur une couche d'interface du type précité était inattendue car, sans éclairement, il a été observé que la couche de revêtement en formation se déposait par ilots et de façon inhomogène. Du fait de l'éclairement pendant le dépôt, la couche de revêtement adhère et présente une bonne uniformité latérale et une bonne homogénéité, en particulier en présence de la couche d'interface.

Il convient d'indiquer en particulier que les performances du dispositif photovoltaïque à base de couches photovoltaïques à base de CuInSe2, obtenues par la mise en oeuvre de l'invention ont permis certes d'augmenter le rendement photovoltaïque, déjà avec l'éclairement pour assister le dépôt de la couche de ZnO sur la sous-couche photovoltaïque. Mais ce dernier rendement a été encore augmenté du fait de la présence d'une couche d'interface (CdS, ZnS, In₂S₃, Ga₂S₃) sur laquelle la couche de revêtement (ZnO) a pu être déposée par électrolyse et avec assistance d'un éclairement. A la connaissance des inventeurs, les résultats atteints par la mise en oeuvre de l'invention sont actuellement les meilleurs pour les dispositifs à base de couches transparentes conductrices déposées par électrolyse, avec des niveaux de rendements comparables à l'état de l'art du procédé classique.

Les couches d'interface peuvent être elles-mêmes couvertes d'une couche intermédiaire d'oxyde de zinc, ou d'un alliage d'oxyde de zinc avec en particulier du magnésium (ZnMgO), déposée par pulvérisation cathodique, par CVD ou en solution. L'invention vise bien en fait la formation d'une couche de revêtement sur un matériau photovoltaïque couvert ou non par d'autres couches préalables. Par exemple, les types d'hétérostructures suivants peuvent être envisagés : CIS/CdS, CIS/ZnS, CIS/CdS/ZnO, CIS/ZnS/ZnO, CIS/ZnO, CIS/In₂S₃, CIS/In₂S₃/ZnO ou autres, avec la couche de ZnO pouvant être dopée ou non, ou encore scindée en une couche dopée et une couche complémentaire non dopée. La couche d'interface à base de ZnO peut être, comme indiqué précédemment, à base de (Zn,Mg)O.

La présente invention vise aussi, en référence à la figure 2, une installation pour la mise en oeuvre du procédé ci-avant, et comportant en particulier un bain d'électrolyse 1 et une source de lumière 2 éclairant ce bain. Pour la commodité de représentation de la figure 2, la rampe d'éclairage 2 est représentée au-dessus du bain. Toutefois, dans une réalisation préférentielle, l'éclairement vient de coté, sensiblement perpendiculaire au substrat, et non par-dessus. La couche peut être déposée en milieu aqueux, organique ou dans leur mélange. La source d'oxygène peut être prévue sous forme d'un bullage 3 d'air ou d'oxygène moléculaire O₂ dissous dans le bain.

L'invention vise aussi la structure photovoltaïque comportant une couche mince de revêtement déposée au-dessus d'une sous-couche à propriétés photovoltaïques, et dans laquelle en particulier la couche de revêtement est une couche d'oxyde transparent déposée directement sur la sous-couche photovoltaïque et présente une morphologie uniforme et homogène au moins à l'interface avec la sous-couche photovoltaïque.

La couche de revêtement peut être caractérisée par une rugosité de surface contrôlée, sous formes de facettes cristallines, de grains colonnaires et/ou d'aiguilles, de façon à pouvoir augmenter le photo-courant que génère la cellule photovoltaïque.

On comprendra ainsi que la mise en oeuvre de l'invention offre une voie possible de synthèse en solution de la couche d'oxyde conductrice et/ou transparente (notamment d'oxyde de zinc), dans les conditions atmosphériques et ne nécessitant pas l'utilisation de réactifs en phase gazeuse. L'invention permet, comme on le verra dans les exemples de réalisation décrits ci-après, l'obtention de couches d'oxyde de zinc transparentes et conductrices conduisant à des dispositifs de rendement similaire à celui obtenu avec la technique de dépôt classique de sputtering. L'invention ouvre donc la voie au remplacement des techniques sous vide pour la fabrication de la couche transparente et conductrice par une méthode électrochimique, très simple, peu couteuse et à bas coût.

En effet, parmi les avantages que procure l'invention :
- le dépôt de la couche de revêtement peut être effectué à basse température (inférieure à 100°C) ne nécessitant pas d'appareillage couteux de dépôt sous vide ou en phase vapeur,
- il est possible de réaliser les dépôts sur de grandes surfaces par une technique de revêtement reproductible sur le plan industriel, et de grand intérêt pour la production de panneaux photovoltaïques à grande échelle et à bas coût.
- il est possible, comme on le verra, de supprimer la couche TRA de la figure 1 (notée « ZnO :i » ci-après, c'est-à-dire la couche d'interface transparente « intrinsèque » (non dopée) recevant habituellement le dépôt de la couche dopée conductrice ELE), ce qui permet de supprimer une étape dans le procédé de fabrication de la cellule solaire,
- il est possible aussi d'éviter, comme on le verra plus loin, l'élément toxique cadmium pour la fabrication de la couche d'interface INT.

D'autres caractéristiques et avantages de l'invention apparaîtront à l'examen de la description détaillée ci-après, et des dessins annexés sur lesquels, outre les figures 1 et 2 décrites ci-avant :
- la figure 3A est une vue obtenue au microscope électronique à balayage en coupe latérale d'un empilement sur verre de molybdène, alliage I-III-VI₂, interface CdS, fenêtre de ZnO intrinsèque, et ZnO électrodéposé au sens de l'invention,
- la figure 3B est un grossissement de la vue de la figure 3A,
- la figure 3C est une vue de dessus de l'empilement des figures 3A et 3B,
- la figure 3D est un grossissement de la vue de la figure 3C,
- la figure 3E représente la caractéristique J-V de l'empilement des figures 3A à 3D,
- la figure 4A est une vue obtenue au microscope électronique à balayage en coupe latérale d'un empilement sur verre de molybdène, alliage I-III-VI₂, interface ZnS, et ZnO directement électrodéposé au sens de l'invention,
- la figure 4B est une vue de dessus de l'empilement de la figure 4A,
- la figure 4C est un grossissement de la vue de la figure 4B,
- la figure 4D représente la caractéristique J-V de l'empilement des figures 4A à 4C,
- la figure 5A est une vue obtenue au microscope électronique à balayage en coupe latérale d'un empilement sur verre de molybdène, d'un alliage I-III-VI₂ et de ZnO directement électrodéposé au sens de l'invention sur l'alliage photovoltaïque,
- la figure 5B est un grossissement de la vue de la figure 5A,
- la figure 5C est une vue de dessus de l'empilement des figures 5A et 5B,
- la figure 5D est un grossissement de la vue de la figure 5C,
- la figure 5E représente la caractéristique J-V d'un empilement sur verre de molybdène, d'alliage I-III-VI₂, et de ZnO directement électrodéposé au sens de l'invention sur l'alliage photovoltaïque,
- la figure 6 représente la caractéristique J-V d'un empilement sur verre de molybdène, alliage I-III-VI₂, interface CdS, et ZnO électrodéposé au sens de l'invention,
- la figure 7 représente la caractéristique J-V d'un empilement sur verre de molybdène, alliage I-III-VI₂, fenêtre de ZnO intrinsèque, et ZnO électrodéposé au sens de l'invention, sur une grande surface (17,5 cm²) alors que les autres caractéristiques J-V ont été relevées sur des petites surfaces (0,1 cm²).

Dans les exemples de réalisation décrits ci-après, la couche de revêtement est à base d'oxyde de zinc déposé par voie électrochimique, à partir d'un sel de zinc dissous dans un solvant aqueux, en présence d'une espèce donneuse d'oxygène, qui peut être très avantageusement de l'oxygène gazeux dissous. L'électrolyte contient également un sel support afin de le rendre conducteur. Le dépôt se fait par application d'un potentiel cathodique à l'électrode suivant la réaction électrochimique suivante :

Zn(II) + 0,5 O₂ + 2e⁻ → ZnO

On comprendra alors que l'apport des électrons notés 2e⁻ est favorisé par le photo-courant que produit la couche photovoltaïque PHO ou de celle-ci couverte de sa couche d'interface pendant son éclairement.

L'oxyde ZnO est déposé sur l'électrode sous forme d'une couche mince, dont l'épaisseur est contrôlée par la quantité d'électricité échangée pendant la réaction. En référence à nouveau à la figure 1, l'électrode recevant le dépôt peut être constituée de l'empilement suivant :
- sur le substrat de verre SUB,
- la couche MET de molybdène (Mo),
- la couche PHO d'alliage I-III-VI₂ tel que du Cu(In,Ga,Al)(S,Se)₂ (noté CIS ci-après),
- la couche avant INT (à base de CdS ou de ZnS),
- la couche avant TRA (ZnO :i), dont il est possible de se passer, de façon avantageuse.
Il convient de rappeler encore que le dépôt de ZnO par électrolyse a pu être effectué directement sur la couche du matériau photovoltaïque à base de l'alliage I-III-VI₂.

Le dépôt est typiquement effectué dans de l'eau à une température autour de 70°C. Il dure environ une heure ou moins et conduit à la formation d'une couche dense d'épaisseur comprise entre 500 et 800 nm.

Des conditions de dépôt, à titre d'exemple, sont décrites ci-après.

L'électrolyte utilisé (appelé "bain chlorure") contient une concentration de 5.10⁻³ M d'ions Zn²⁺ introduits dans de l'eau déminéralisée (18 M.cm⁻³) sous forme de sel de ZnCl₂ et 0,1 M d'ions Cl⁻ introduits sous forme de sel KCl. Le bain est saturé en oxygène par le recours à un bullage d'oxygène gazeux. Le bain est maintenu à une température de 70°C pendant toute la durée de l'électrodépôt. L'agitation est assurée par l'utilisation d'un barreau aimanté. La référence de potentiel est une électrode au sulfate mercureux saturée en K₂SO₄ (Hg/Hg₂SO₄/K₂SO₄(saturé) (ESM)). Elle est placée dans un compartiment séparé de la solution d'électrolyse par un fritté d'alumine de faible porosité rempli d'une solution saturée de sulfate de potassium. Un pont électrolytique permet de la maintenir à température ambiante afin d'éviter toute fluctuation de potentiel pouvant apparaître sous l'effet de la température lorsque le bain est chauffé. Le potentiel de dépôt a été fixé à -1,4V/ESM. Une plaque de zinc est utilisée comme contre-électrode et permet à la fois le passage du courant dans le circuit extérieur et la régénération de l'électrolyte en ions Zn²⁺ évitant ainsi son épuisement par consommation à l'électrode de travail.

La conductivité des couches est obtenue par ajout dans la solution d'impuretés dopantes, par exemple et comme décrit ci-avant des ions chlorures incorporés dans la couche, laquelle présente alors une conductivité élevée et stable dans le temps, ce qui constitue une propriété avantageuse pour le fonctionnement des dispositifs solaires.

Au sens de l'invention, une source de lumière est utilisée pour assister le dépôt, au moins pendant la phase de nucléation.

Le flux lumineux est fourni par un simulateur solaire dont le flux lumineux homogène est d'environ 100 mW/cm² à 15 cm de distance. Ce flux peut être ajusté en modifiant la distance entre la lampe et la couche, jusqu'à 5 m dans la configuration utilisée, ce qui permet de réduire le flux arrivant à la surface de l'échantillon jusqu'à quelques mW/cm². Dans les conditions de cet exemple, les densités de courant utilisées durant le dépôt sont situées entre 0,1 et 0,4 mA/cm². Afin de favoriser la transmission de la lumière à travers le réacteur électrochimique et gagner en homogénéité d'illumination, une cellule parallélépipédique en verre est utilisée, l'échantillon étant placé verticalement dans cette configuration, et l'éclairement étant effectué horizontalement. Le dépôt de la couche de ZnO dure généralement entre une demi-heure et une heure.

Une fois le dépôt réalisé, les cellules sont complètes et sont caractérisées de façon classique.

Le dépôt des couches de ZnO par électrolyse suivant le procédé de l'invention a permis l'obtention de rendements de conversion photovoltaïque de plus de 12%, atteignant dans certains cas une valeur record de 16,3%. Ces rendements sont comparables à ceux obtenus avec la technique de dépôt du ZnO par pulvérisation (« sputtering »).

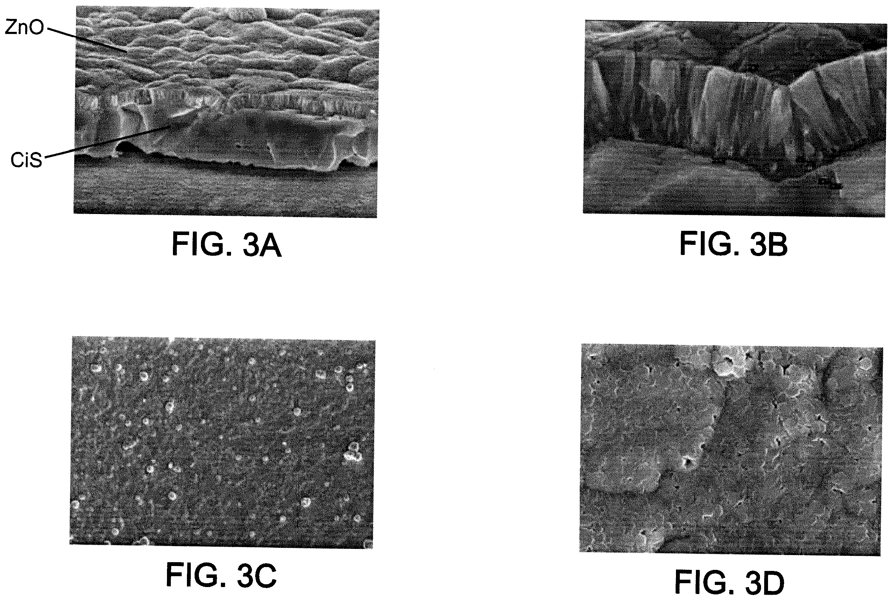

On a représenté, en référence aux figures 3A à 3D, la morphologie d'un empilement de type Mo/CIS (ou CIGS pour une légère incorporation de gallium)/CdS/ZnO :i et ZnO par électrodépôt au sens de l'invention. Ainsi, on a remplacé ici la couche conductrice de ZnO préparée habituellement par sputtering par une couche de ZnO déposée par électrolyse au sens de l'invention.

Les images sont obtenues par microscopie électronique à balayage. On observe un bon recouvrement compact et homogène du ZnO électrodéposé (figure 3A) sur les couches sous-jacentes, notamment de CIGS. En particulier, la couche de ZnO électrodéposée est très couvrante et homogène en épaisseur. En référence à la figure 3D, la couche de ZnO est, dans l'exemple représenté, de surface à facettes cristallines.

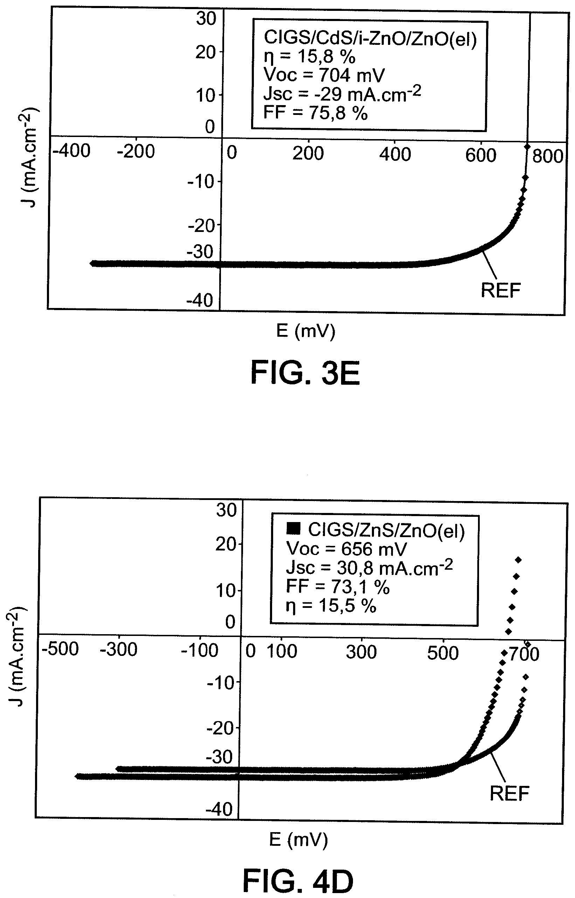

La caractéristique densité de courant surfacique v/ tension (notée ci-après « caractéristique J-V ») de ce type d'empilement est représentée sur la figure 3E sur laquelle on note une tension en circuit ouvert Voc de 704mV et une densité de photo-courant de court-circuit Jsc de -29mA/cm² pour un facteur de forme FF de 75,8% et un rendement η de 15,8%. Ce rendement est bien comparable à celui de 16,2% pour un même empilement réalisé dans les mêmes conditions mais avec une couche de ZnO superficielle obtenue par sputtering au sens de l'état de l'art. Il convient d'indiquer que l'électrodépôt de ZnO au sens de l'invention peut être effectué sur des structures CIGS/CdS /ZnO :i préparées de façon classique, sans aucune adaptation. D'ailleurs, sur des échantillons CIGS/CdS /ZnO :i provenant d'un autre centre d'essai, une couche de ZnO a été électrodéposée par le procédé au sens de l'invention et les résultats sont très similaires :
- Voc = 649 mV,
- Jsc = -30,1 mA.cm⁻²,
- FF = 71,7%
- η =14,7 %,
ce qui exprime bien la flexibilité de la technique de dépôt par électrolyse.

La caractéristique J-V de la figure 3E est notée REF et les caractéristiques J-V des empilements décrits ci-après sont comparées à cette caractéristique REF.

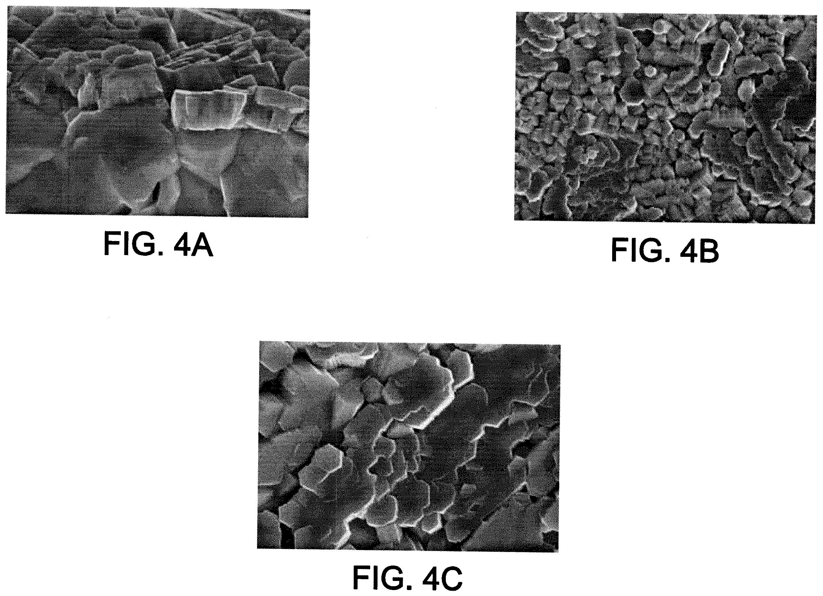

En référence maintenant aux figures 4A à 4D, dans le cas d'un empilement de type Mo/CIGS/ZnS et ZnO par électrodépôt au sens de l'invention, on observe encore une couche superficielle bien compacte de ZnO à facettes cristallines (figure 4C). La couche de ZnS est déposée par voie chimique en solution (technique de dépôt appelée « CBD » pour « chemical bath deposition »).

La caractéristique J-V de ce type d'empilement est représentée sur la figure 4D sur laquelle on note les paramètres Voc =656mV et Jsc =-30,8mA/cm² pour un facteur de forme FF =73,1% et un rendement η de 15,5%, nonobstant le remplacement du CdS par du ZnS et la suppression de la couche de ZnO non dopée.

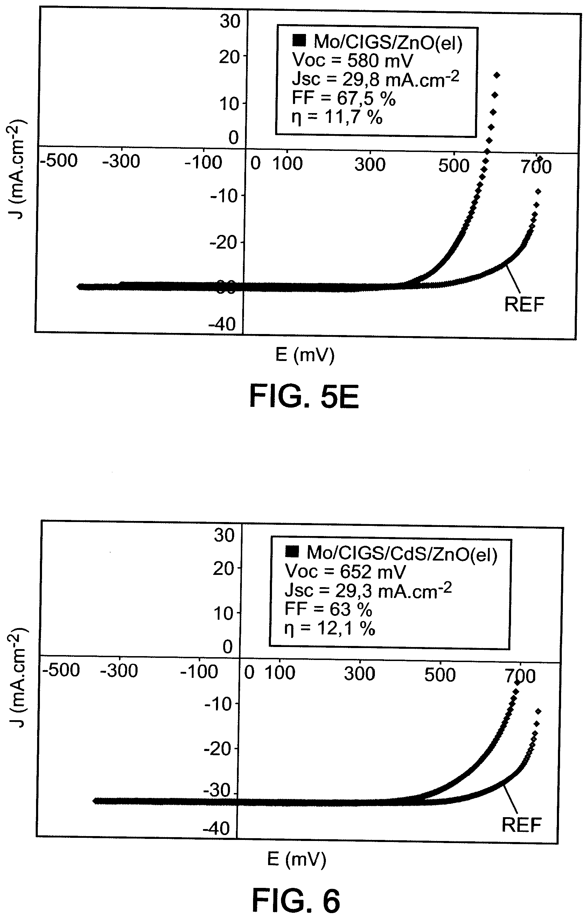

En référence maintenant au cas d'un empilement de type Mo/CIGS/CdS et ZnO par électrodépôt au sens de l'invention, il a pu être observé encore une couche superficielle de ZnO homogène et compacte. La caractéristique J-V de ce type d'empilement est représentée sur la figure 6 sur laquelle on note les paramètres Voc =652mV et Jsc =-29,3mA/cm² pour un facteur de forme FF =63% et un rendement η de 12,1%, nonobstant la suppression de la couche de ZnO non dopée. On relèvera néanmoins ici que le remplacement du cadmium par du zinc dans la couche d'interface INT procurait de meilleurs résultats dans l'exemple précédent des figures 4A à 4D.

On peut donc constater que la gamme de rendements obtenus est comparable à celle où une couche de ZnO intrinsèque est pulvérisée avant l'électrodépôt du ZnO. Le procédé selon l'invention peut s'appliquer donc directement après l'étape classique de dépôt de CdS ou de ZnS sans nécessiter le retour sous vide pour déposer la couche de ZnO :i. Les résultats semblent en outre plus performants lorsque la couche d'interface est à base de ZnS plutôt que de CdS.

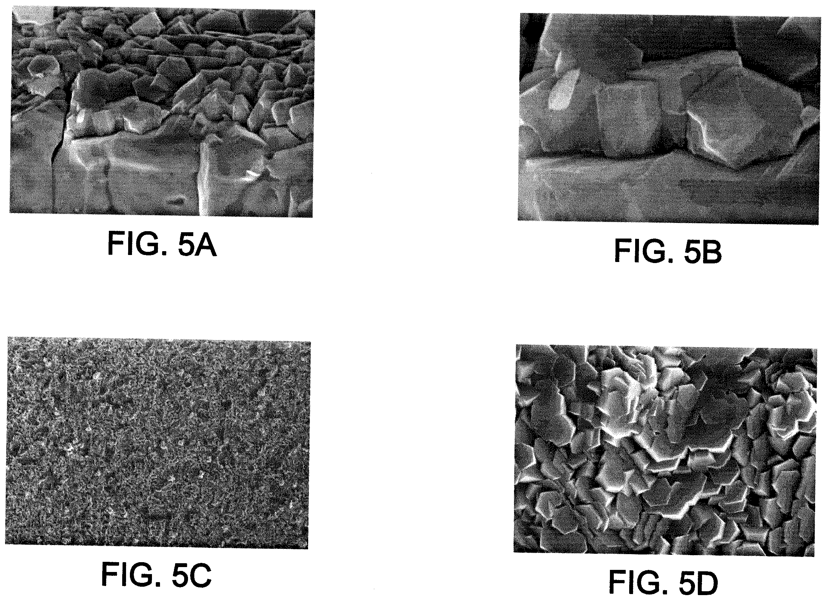

En référence maintenant aux figures 5A à 5E dans le cas d'un empilement de type Mo/CIGS et ZnO déposé directement par électrodépôt au sens de l'invention, on observe encore une couche superficielle de ZnO à facettes cristallines (figure 5D) d'homogénéité et de compacité satisfaisantes (Figure 5A). On a représenté sur la figure 5E la caractéristique J-V d'un empilement de type ZnO électrodéposé directement sur CIGS et on relève des résultats qui restent néanmoins satisfaisants avec :
- Voc =580mV,
- Jsc =-29,8mA/cm²,
- FF = 67,5%,
- et le rendement η =11,7%.

Certes, les performances sont sensiblement moins bonnes qu'avec les couches tampons de CdS ou de ZnS, mais elles restent cependant nettement supérieures à 10%, ce qui valide cette mise en oeuvre de l'invention dans les applications photovoltaïques.

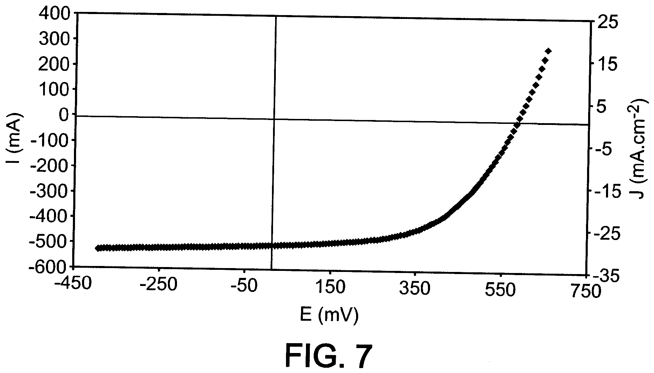

La technique de dépôt au sens de l'invention peut être appliquée sur de grandes surfaces de façon homogène, avec des résultats allant jusqu'à 9,5 % en rendement pour l'empilement Verre/Mo/CIS(EVAP)/CdS(CBD)/ZnO :i(SPUT)/ZnO (ED), sur des plaques de 17,5 cm². La figure 7 représente la caractéristique J-V d'une telle structure.

L'utilisation de la lumière pour assister l'électrodépôt, au sens de l'invention, provoque une amélioration spectaculaire de l'homogénéité latérale du dépôt. Cet avantage se présente comme un point clé de l'application du procédé au sens de l'invention aux grandes surfaces. Typiquement, le dépôt pourrait être effectué sur des surfaces allant jusqu'à l'ordre de 1 m² ou au-delà grâce à un dispositif d'électrolyse approprié.

Globalement, les rendements obtenus sont élevés pour des cellules à base de CIS avec une couche fenêtre à base de CdS. L'utilisation de substrats CIS avec des couches d'interface à base de ZnS est originale et très prometteuse. Par ailleurs, le dépôt par électrolyse de la couche superficielle de ZnO permet de s'affranchir définitivement de la couche sous-jacente intrinsèque de ZnO (ou ZnMgO) déposée habituellement par sputtering (référence TRA de la figure 1).

Bien entendu, la présente invention ne se limite pas à la forme de réalisation décrite ci-avant à titre d'exemple ; elle s'étend à d'autres variantes.

Par exemple, l'électrodépôt de la couche de revêtement d'oxyde transparent et/ou conducteur peut être effectué en fixant le potentiel à l'électrode (en mode dit « potentiostatique », dans une réalisation préférée) ou en fixant le courant traversant l'électrode (en mode dit « intentiostatique »).

## Revendications

1. Procédé de fabrication d'une structure photovoltaïque, ladite structure comportant une couche de revêtement (ELE, TRA) à base d'oxyde de zinc déposée au-dessus d'une sous-couche à propriétés photovoltaïques (PHO),
**caractérisé en ce que** le dépôt de la couche de revêtement est réalisé par électrochimie et assisté au moins en partie par un éclairement issu d'une source de lumière, l'éclairement étant dans une gamme spectrale comprise entre 100 et 1500 nm et de puissance incidente comprise entre 0,1 mW/cm² et 1 W/cm².

2. Procédé selon la revendication 1, **caractérisé en ce que** la couche de revêtement est destinée à intervenir comme fenêtre transparente et/ou conductrice d'une cellule photovoltaïque.

3. Procédé selon la revendication 1 ou 2, **caractérisé en ce que** la couche est déposée par électrolyse à partir d'ions zinc dissous dans un bain d'électrolyse, par une réaction cathodique.

4. Procédé selon la revendication 3, **caractérisé en ce que** la réaction cathodique se fait en présence d'un élément donneur d'oxygène tel que de l'oxygène, du peroxyde d'hydrogène et/ou de nitrates.

5. Procédé selon l'une des revendications précédentes, **caractérisé en ce que** la couche de revêtement (ELE) est rendue conductrice par dopage par au moins un élément introduit en solution parmi le chlore, le fluor, l'iode, le brome, le gallium, l'indium, le bore et l'aluminium.

6. Procédé selon l'une des revendications précédentes, **caractérisé en ce que** la sous-couche photovoltaïque (PHO) est constituée d'un alliage I-III-VI₂ du type Cu(In,Ga,Al)(S,Se)₂.

7. Procédé selon l'une des revendications précédentes, **caractérisé en ce que** la couche de revêtement (ELE) est déposée directement sur la sous-couche photovoltaïque (PHO).

8. Procédé selon l'une des revendications 1 à 6, **caractérisé en ce que** la couche de revêtement est déposée sur au moins une couche d'interface (INT) située au-dessus de la sous-couche photovoltaïque.

9. Procédé selon la revendication 8, **caractérisé en ce que** la couche d'interface est une couche à base de sulfure de cadmium.

10. Procédé selon la revendication 9, **caractérisé en ce que** la couche d'interface est une couche à base de sulfure de zinc.

11. Procédé suivant la revendication 9, **caractérisé en ce que** la couche d'interface est une couche à base de sulfure d'indium ou de gallium.

12. Procédé selon l'une des revendications 9 à 11, **caractérisé en ce que** la couche d'interface est recouverte d'une couche d'oxyde de zinc non dopé ou d'un alliage d'oxyde de zinc non dopé.

13. Procédé selon l'une des revendications précédentes, **caractérisé en ce que** le dépôt de la couche de revêtement par électrochimie est réalisé à une température dans une gamme de 50°C à 150°C.

14. Installation pour la mise en oeuvre du procédé selon l'une des revendications précédentes, l'installation comportant un bain d'électrolyse (1) comprenant des ions zinc dissous dans ledit bain d'électrolyse et une source de lumière éclairant la couche photovoltaïque, **caractérisée en ce que** la source de lumière (2) est configurée pour la mise en oeuvre d'un éclairement dans une gamme spectrale comprise entre 100 et 1500 nm et de puissance incidente comprise entre 0,1 mW/cm² et 1 W/cm².

## Patentansprüche

1. Verfahren zur Herstellung einer Photovoltaikstruktur, wobei die Struktur eine Deckschicht (ELE, TRA) auf der Basis von Zinkoxid umfasst, die auf einer Unterschicht mit Photovoltaikeigenschaften (PHO) abgeschieden wird,
**dadurch gekennzeichnet, dass** die Abscheidung der Deckschicht durch Elektrochemie vorgenommen wird und mindestens teilweise durch eine Bestrahlung von einer Lichtquelle unterstützt wird, wobei die Bestrahlung in einem Spektralbereich zwischen 100 und 1500 nm liegt und eine Einfallsleistung zwischen 0,1 mW/cm² und 1 W/cm² aufweist.

2. Verfahren nach Anspruch 1,
**dadurch gekennzeichnet, dass** die Deckschicht dazu bestimmt ist, als transparentes und/oder leitendes Fenster einer Photovoltaikzelle zu dienen.

3. Verfahren nach Anspruch 1 oder 2,
**dadurch gekennzeichnet, dass** die Schicht durch Elektrolyse mit Zinkionen, die in einem Elektrolysebad gelöst sind, durch eine Kathodenreaktion abgeschieden wird.

4. Verfahren nach Anspruch 3,
**dadurch gekennzeichnet, dass** die Kathodenreaktion in Anwesenheit eines sauerstoffspendenden Elements, wie Sauerstoff, Wasserstoffperoxid und/oder Nitrate, erfolgt.

5. Verfahren nach einem der vorhergehenden Ansprüche,
**dadurch gekennzeichnet, dass** die Deckschicht (ELE) durch Dotierung mit mindestens einem Element, das in Lösung eingebracht wird, von Chlor, Fluor, Iod, Brom, Gallium, Indium, Bor und Aluminium leitend gemacht wird.

6. Verfahren nach einem der vorhergehenden Ansprüche,
**dadurch gekennzeichnet, dass** die Photovoltaikunterschicht (PHO) aus einer Legierung I-III-VI₂ vom Typ Cu(In,Ga,Al) (S, Se)₂ besteht.

7. Verfahren nach einem der vorhergehenden Ansprüche,
**dadurch gekennzeichnet, dass** die Deckschicht (ELE) direkt auf der Photovoltaikunterschicht (PHO) abgeschieden wird.

8. Verfahren nach einem der Ansprüche 1 bis 6,
**dadurch gekennzeichnet, dass** die Deckschicht auf mindestens einer Grenzflächenschicht (INT) abgeschieden wird, die über der Photovoltaikunterschicht angeordnet ist.

9. Verfahren nach Anspruch 8,
**dadurch gekennzeichnet, dass** die Grenzflächenschicht eine Schicht auf der Basis von Cadmiumsulfid ist.

10. Verfahren nach Anspruch 9,
**dadurch gekennzeichnet, dass** die Grenzflächenschicht eine Schicht auf der Basis von Zinksulfid ist.

11. Verfahren nach Anspruch 9,
**dadurch gekennzeichnet, dass** die Grenzflächenschicht eine Schicht auf der Basis von Indium- oder Galliumsulfid ist.

12. Verfahren nach einem der Ansprüche 9 bis 11,
**dadurch gekennzeichnet, dass** die Grenzflächenschicht mit einer Schicht aus undotiertem Zinkoxid oder einer undotierten Zinkoxid-Legierung bedeckt wird.

13. Verfahren nach einem der vorhergehenden Ansprüche,
**dadurch gekennzeichnet, dass** die Abscheidung der Deckschicht durch Elektrochemie bei einer Temperatur in einem Bereich von 50°C bis 150°C vorgenommen wird.

14. Anlage zur Durchführung des Verfahrens nach einem der vorhergehenden Ansprüche, umfassend ein Elektrolysebad (1), umfassend Zinkionen, die in dem Elektrolysebad gelöst sind, und eine Lichtquelle, welche die Photovoltaikschicht bestrahlt,
**dadurch gekennzeichnet, dass** die Lichtquelle (2) für die Durchführung einer Bestrahlung in einem Spektralbereich zwischen 100 und 1500 nm und mit einer Einfallsleistung zwischen 0,1 mW/cm² und 1 W/cm² ausgelegt ist.

## Claims

1. Process for producing a photovoltaic structure, said structure comprising a coating layer (ELE, TRA) based on zinc oxide deposited on top of a sublayer having photovoltaic properties (PHO), **characterized in that** the coating layer is deposited electrochemically, the deposition being at least partly assisted by illuminance coming from a light source, the illuminance being within a spectral range between 100 and 1500 nm and with an incident power between 0.1 Mw/cm² and 1 W/cm^{2.}

2. Process according to Claim 1, **characterized in that** the coating layer is intended to act as transparent and/or conductive window of a photovoltaic cell.

3. Process according to Claim 1 or 2, **characterized in that** the layer is deposited by electrolysis with zinc ions dissolved in an electrolysis bath, by a cathodic reaction.

4. Process according to Claim 3, **characterized in that** the cathodic reaction takes place in the presence of an oxygen donor element such as oxygen, hydrogen peroxide and/or nitrates.

5. Process according to one of the preceding claims, **characterized in that** the coating layer (ELE) is made conductive by doping with at least one element introduced in solution, taken from chlorine, fluorine, iodine, bromine, gallium, indium, boron and aluminum.

6. Process according to one of the preceding claims, **characterized in that** the photovoltaic sublayer (PHO) consists of a I-III-VI₂ alloy of the Cu(In,Ga,Al) (S, Se)₂ type.

7. Process according to one of the preceding claims, **characterized in that** the coating layer (ELE) is deposited directly on the photovoltaic sublayer (PHO).

8. Process according to one of Claims 1 to 6, **characterized in that** the coating layer is deposited on at least one interface layer (INT) located above the photovoltaic sublayer.

9. Process according to Claim 8, **characterized in that** the interface layer is a layer based on cadmium sulfide.

10. Process according to Claim 9, **characterized in that** the interface layer is a layer based on zinc sulfide.

11. Process according to Claim 9, **characterized in that** the interface layer is a layer based on indium sulfide or gallium sulfide.

12. Process according to one of Claims 9 to 11, **characterized in that** the interface layer is covered with a layer of undoped zinc oxide or an undoped zinc oxide alloy.

13. Process according to one of the preceding claims, **characterized in that** the coating layer is deposited electrochemically at a temperature in the 50°C to 150°C range.

14. Installation for implementing the process according to one of the preceding claims, the installation comprising an electrolysis bath (1) comprising zinc ions dissolved in said electrolysis bath and a light source illuminating the photovoltaic layer, **characterized in that** the light source (2) is configured to deliver an illuminance within a spectral range between 100 and 1500 nm and with an incident power between 0.1 Mw/cm² and 1 W/cm².
